# EUROPEAN PATENT SPECIFICATION

(11) **EP 3 920 217 B1**
(45) Date of publication and mention of the grant of the patent: **12.06.2024**
(21) Application number: 20748784.4
(22) Date of filing: 28.01.2020
(51) Int. Cl.: H01L 23/473, H01L 23/467, H01L 23/373

(54) **HEATSINK MEMBER AND ELECTRONIC DEVICE PROVIDED WITH SAME**
KÜHLKÖRPERELEMENT UND DAMIT AUSGESTATTETE ELEKTRONISCHE VORRICHTUNG
ÉLÉMENT DISSIPATEUR THERMIQUE ET DISPOSITIF ÉLECTRONIQUE ÉQUIPÉ DE CELUI-CI

(30) Priority: 30.01.2019 JP 2019014447
(43) Date of publication of application: 08.12.2021
(73) Proprietor: Kyocera Corporation, Kyoto-shi, Kyoto 612-8501 (JP)
(72) Inventor: MUNEISHI,Takeshi, Kyoto-shi, Kyoto 612-8501 (JP)
(74) Representative: Viering, Jentschura & Partner mbB Patent- und Rechtsanwälte
(86) International application number: PCT/JP2020/003000
(87) International publication number: WO 2020/158739

(56) References cited:
- WO-A1-2015/147071
- WO-A1-2017/104830
- JP-A- H0 483 368
- JP-A- 2005 032 881
- JP-A- 2006 165 165
- US-A1- 2005 082 037
- US-A1- 2007 102 140
- US-B1- 6 196 307

## Description

### Technical Field

The present disclosure relates to a heat dissipation member and an electronic device provided with the same.

### Background Art

An electronic device for high power applications is used in a railway vehicle and the like. Examples of such an electronic device include an inverter provided with an electronic component such as a semiconductor element such as an insulated-gate bipolar transistor (IGBT) or the like.

Here, in an electronic device for high power applications, a great amount of heat is generated by the electronic component due to switching loss, conduction loss, and the like, and thus a heat dissipation member for cooling the electronic component is provided (for example, see Patent Document 1). Patent Document 2 discloses a heat exchanger and method for cooling power electronics modules. The power electronics module transferring heat generated during operation to the heat exchanger through a thermal base of the power module. The heat exchanger being directly bonded to the thermal base and comprising a metal foam. The metal foam having a network of metal ligaments forming numerous open cells to provide porosity. The metal ligaments are aligned to provide a higher metal density in cross-sectional planes of the foam perpendicular to the intended direction of heat flow.

### Citation List

### Patent Document

Patent Document 1: JP 2002-93975 A,
Patent Document 2: US 6 196 307 B1

### Summary

The present invention provides a heat dissipation member according to claim 1, a heat dissipation member according to claim 4, and an electronic device according to claim 12.

Further embodiments are described in the dependent claims.

### Brief Description of Drawings

FIG. 1 is an example of an electronic device of the present disclosure.
FIG. 2 is an example of a cross-sectional view taken along line A-A' illustrated in FIG. 1.
FIG. 3 is an example of an enlarged view of a portion S illustrated in FIG. 2.
FIG. 4 is an example of an enlarged view of the portion S illustrated in FIG. 2.
FIG. 5 is an example of a cross-sectional view taken along line A-A' illustrated in FIG. 1.

### Description of Embodiments

A heat dissipation member and an electronic device according to the present disclosure will be described in detail below with reference to the drawings.

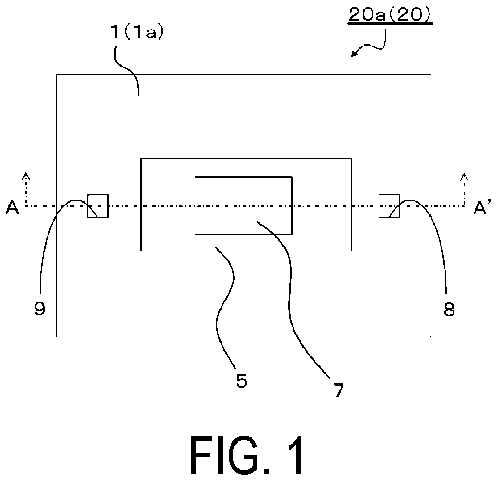

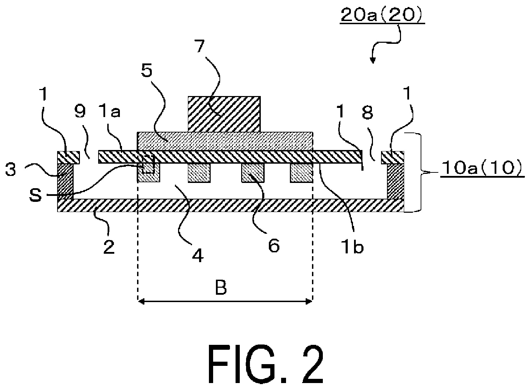

First, as illustrated in FIGS. 1 and 2, a heat dissipation member 10 of the present disclosure includes a first wall part 1; a second wall part 2 located opposite the first wall part 1; a third wall part 3 located between the first wall part 1 and the second wall part 2; a flow path 4 surrounded by the first wall part 1, the second wall part 2, and the third wall part 3; and a conductive layer 5 located on an outer surface 1a of the first wall part 1.

Here, the first wall part 1 has insulating properties and may be made of a ceramic, glass, resin, or the like, for example. Furthermore, the second wall part 2 and the third wall part 3 need not have insulating properties and may be made of any material. However, from the perspective of having a similar thermal expansion coefficient as the first wall part 1, the second wall part 2 and the third wall part 3 preferably are made from the same material as the first wall part 1.

Also, in the example illustrated in FIG. 1, an inflow opening 8 and an outflow opening 9 of the flow path 4 are open in the first wall part 1. However, no such limitation is intended, and, naturally, the inflow opening 8 and the outflow opening 9 may be open in the second wall part 2 or the third wall part 3 instead of the first wall part 1.

In addition, a cooling medium (hereinafter referred to as a refrigerant) flows through the flow path 4, and the refrigerant may be a liquid or gas. Here, as a liquid refrigerant, pure water, a fluorine-based liquid, or the like may be used, and an anticorrosive may be added to these.

Furthermore, the conductive layer 5, by conducting electricity, functions as an electrode, wiring, or a terminal, and an electronic device 20 of the present disclosure is obtained by placing an electronic component 7 on the conductive layer 5.

Here, the material constituting the conductive layer 5 may be any material provided that it is electrically conductive, and may be, for example, copper, aluminum, or the like.

In addition to semiconductor elements, a heating element for a sublimation type thermal printer head or a thermal inkjet printer head, a Peltier element, a capacitor, or the like may be used as the electronic component 7.

The heat dissipation member 10 of the present disclosure includes a first metal layer 6 located on an inner surface 1b of the first wall part 1. Accordingly, heat generated from the electronic component 7 is transferred to the first metal layer 6 via the conductive layer 5 and the first wall part 1 and is dissipated by heat exchange between the first metal layer 6 and the refrigerant flowing in the flow path 4.

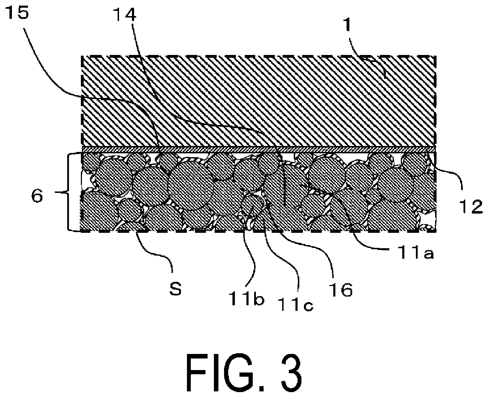

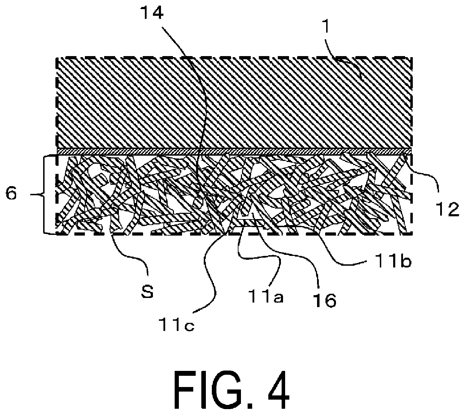

Here, as illustrated in FIGS. 3 and 4, the first metal layer 6 of the heat dissipation member 10 of the present disclosure may include first metal particles 11a and second metal particles 11b. Gaps 16 may be located between the first metal particles 11a and the second metal particles 11b. With this configuration satisfied, compared to a case where the first metal layer 6 is dense, the surface area where the first metal layer 6 comes into contact with the refrigerant flowing through the flow path 4 is increased, and heat dissipation can be efficiently performed. Thus, the heat dissipation member 10 of the present disclosure can efficiently cool the electronic component 7. Furthermore, the electronic device 20 of the present disclosure includes the heat dissipation member 10 of the present disclosure and thus has excellent reliability.

As illustrated in FIGS. 3 and 4, the shape of the first metal particles 11a and the second metal particles 11b may be spherical, granular, whisker-like, or needle-like, for example. In a case where the first metal particles 11a and the second metal particles 11b are whisker-like or needle-like, the first metal particles 11a and the second metal particles 11b may be bent. The first metal particles 11a and the second metal particles 11b may include corner portions. In a case where the first metal particles 11a and the second metal particles 11b are spherical or granular, the longitudinal length of the first metal particles 11a and the second metal particles 11b may range from 0.5 µm to 200 µm. In a case where the first metal particles 11a and the second metal particles 11b are whisker-like or needle-like, the fiber diameter may range from 1 µm to 100 µm, and the length may range from 100 µm to 5 mm.

In FIG. 3, the first metal particles 11a and the second metal particles 11b are granular. In FIG. 4, the first metal particles 11a and the second metal particles 11b are whisker-like.

Here, porosity may be used as an indicator of the denseness of the first metal layer 6, and the porosity of the first metal layer 6 ranges from 10% to 90%, for example. Here, the porosity of the first metal layer 6 may be calculated by performing measurement using the Archimedes method, for example.

As illustrated in FIGS. 3 and 4, the first metal layer 6 may include third metal particles 11c. The first metal layer 6 may include a welded part 14 between the first metal particles 11a and the third metal particles 11c. Since the first metal particles 11a and the third metal particles 11c are welded together rather than just simply in contact with one another, the first metal particles 11a and the third metal particles 11c easily transfer heat between one another. Thus, the entirety of the first metal layer 6 has high thermal conductivity. Thus, the heat dissipation member 10 has high reliability.

The material of the first metal layer 6 is only required to be a metal and may be, for example, stainless steel, aluminum, or copper. Note that the thermal expansion coefficient of these materials are generally as follows: approximately 10 to 18 ppm for stainless steel, approximately 23 ppm for aluminum, and approximately 16.7 ppm for copper.

Furthermore, the first wall part 1 of the heat dissipation member 10 of the present disclosure may be made from a ceramic. With this configuration satisfied, heat resistance and mechanical strength are excellent, and the reliability of the heat dissipation member 10 can be improved. Here, the ceramic constituting the first wall part 1 may be an alumina ceramic, an alumina-zirconia composite ceramic, an aluminum nitride ceramic, a silicon nitride ceramic, or the like.

In particular, the heat dissipation property of the heat dissipation member 10 of the present disclosure is improved in a case where the first wall part 1 is made of a ceramic, in particular a silicon nitride ceramic.

Here, a silicon nitride ceramic includes 70 mass% or more of silicon nitride per 100 mass% of all components of the ceramic. The material constituting the first wall part 1 can be confirmed by the following method. First, a value of 2θ (2θ indicates a diffraction angle) obtained by measurement using an X-ray diffractometer (XRD) is identified via a JCPDS card. Next, a quantitative analysis of each component is performed using an ICP emission spectrophotometer (ICP) or an X-ray fluorescent (XRF) analyzer. Then, using XRD, the presence of silicon nitride is confirmed, and in a case where the amount of silicon nitride obtained by converting the amount of Si measured via ICP or XRF into an equivalent amount of silicon nitride (Si₃N₄) is 70 mass% or more, the sample is a silicon nitride ceramic. Note that the same applies to other ceramics.

Note that although the thermal expansion coefficient of metals is greater than the thermal expansion coefficient of ceramics, because the first metal layer 6 is configured to include gaps, the thermal expansion of the first metal layer 6 is less than that of a dense first metal layer. Thus, the first wall part 1 made of a ceramic and the first metal layer 6 including the gaps have a small difference in thermal expansion, and the stress generated due to the difference in thermal expansion is small. Accordingly, even in a case where heating and cooling associated with the heat generated by the electronic component 7 is repeated, the stress placed on the part of the first wall part 1 near the first metal layer 6 is small, and cracking is less likely to occur in the first wall part 1.

Note that the thermal expansion coefficient of ceramics is generally as follows: approximately 7.2 ppm for an alumina ceramic, approximately 4.6 ppm for an aluminum nitride ceramic, approximately 2.8 ppm for a silicon nitride ceramic, approximately 10.0 ppm for a zirconia ceramic, and in the case of an alumina-zirconia composite ceramic, approximately 7 to 10 ppm.

Furthermore, the second wall part 2 and the third wall part 3 may be made of a ceramic different from that of the first wall part 1. For example, in a case where the first wall part 1 is made of a silicon nitride ceramic and the second wall part 2 and the third wall part 3 are made of a silicon carbide ceramic, because the silicon carbide ceramic has a higher thermal conductivity than the silicon nitride ceramic, durability can be maintained and heat dissipation can be improved compared with a case where the first wall part 1, the second wall part 2, and the third wall part 3 are all made of a silicon nitride ceramic. Furthermore, in a case where the first wall part 1 is made of a silicon nitride ceramic and the second wall part 2 and the third wall part 3 are made of an alumina ceramic, the manufacturing cost of the alumina ceramic is lower than that of the silicon nitride ceramic, so the heat dissipation member 10 can be manufactured inexpensively.

Additionally, the second wall part 2 and the third wall part 3 may have a density smaller than that of the first wall part 1. With this configuration satisfied, the heat dissipation member 10 can be reduced in weight while maintaining durability. For example, in a case where the first wall part 1 is made of a silicon nitride ceramic (approximately 3.3 g/cm³), by the second wall part 2 and the third wall part 3 being made of aluminum (approximately 2.7 g/cm³) if a metal is used, a polyimide resin (approximately 1.4 g/cm³) if a resin is used, or a cordierite ceramic (approximately 2.5 g/cm³) if a ceramic is used, the density of the second wall part 2 and the third wall part 3 is made smaller than that of the first wall part 1.

Additionally, as illustrated in FIGS. 3 and 4, the heat dissipation member 10 of the present disclosure may include a bonding layer 12 located between the first metal layer 6 and the inner surface 1b of the first wall part 1. With this configuration satisfied, the first metal layer 6 is unlikely to peel from the first wall part 1, and the bonding layer 12 alleviates the stress generated due to the difference in thermal expansion making cracking less likely to occur in the first wall part 1. Thus, the heat dissipation member 10 of the present disclosure can be used over an extended period of time. Note that the average thickness of the bonding layer 12 may range from 1 µm to 0.5 mm, for example.

Furthermore, the bonding layer 12 in the heat dissipation member 10 of the present disclosure may be made of a metal or glass. Here, the metal may be, for example, nickel, platinum, SUS, aluminum, copper, or the like, and the glass may be, for example, a borosilicate glass, a silicate-based glass, or the like. With this configuration satisfied, the first metal layer 6 and the first wall part 1 are firmly joined together by the bonding layer 12, and the first metal layer 6 is less likely to peel off from the first wall part 1.

Alternatively, the bonding layer 12 in the heat dissipation member 10 of the present disclosure may be made of a porous ceramic. Here, in a case where the first wall part 1 is made of a ceramic, the porous ceramic may be made of the same component as the first wall part 1, for example. With this configuration satisfied, the first metal particles 11a, the second metal particles 11b, and the third metal particles 11c that constitute the first metal layer 6 enter the porous bonding layer 12, firmly joining together the first metal layer 6 and the bonding layer 12. Furthermore, in a case where the first wall part 1 is a ceramic, because the first wall part 1 and the bonding layer 12 are both ceramics, the first wall part 1 and the bonding layer 12 are firmly joined together. Thus, the first metal layer 6 is less likely to detach from the first wall part 1.

Additionally, as illustrated in FIG. 3, the first metal particles 11a and the second metal particles 11b in the heat dissipation member 10 of the present disclosure may be covered with an oxide film 15. With this configuration satisfied, chemical reactions between the first metal particles 11a and the second metal particles 11b that constitute the first metal layer 6 and the refrigerant flowing in the flow path 4 can be suppressed, and the heat dissipation member 10 of the present disclosure can be stably used for an extended period of time. Furthermore, the third metal particles 11c may also be covered with the oxide film 15. The first metal particles 11a, the second metal particles 11b, and the third metal particles 11c may be covered with the oxide film 15. With this configuration satisfied, chemical reactions between the first metal particles 11a, the second metal particles 11b, and the third metal particles 11c that constitute the first metal layer 6 and the refrigerant flowing in the flow path 4 can be suppressed, and the heat dissipation member 10 of the present disclosure can be stably used for an extended period of time. Note that the oxide film 15 may be an oxide of a metal constituting the first metal particles 11a, the second metal particles 11b, or the third metal particles 11c.

Additionally, as illustrated in FIG. 2, in the heat dissipation member 10 of the present disclosure, the first metal layer 6 may be located directly below the conductive layer 5. Here, "the first metal layer 6 may be located directly below the conductive layer 5" means that at least a part of the first metal layer 6 is located within a region B directly below the conductive layer 5 in a cross-section orthogonal to the direction in which the refrigerant in the flow path 4 flows, as illustrated in FIG. 2. Naturally, the first metal layer 6 may also be completely disposed within the region B. With this configuration satisfied, the heat generated from the electronic component 7 is transmitted directly to the first metal layer 6 via the conductive layer 5 and the first wall part 1 and dissipated to the refrigerant flowing in the flow path 4. Thus, the cooling efficiency of the heat dissipation member 10 of the present disclosure is improved.

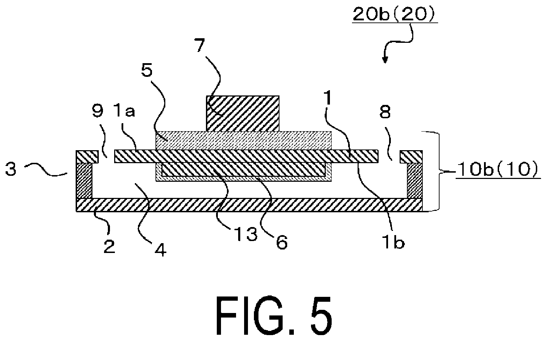

Additionally, as illustrated in FIG. 5, the first wall part 1 of the heat dissipation member 10 of the present disclosure may include a projecting part 13 projecting toward the flow path 4, and the first metal layer 6 may be located on the top surface of the projecting part 13. Here, the projecting part 13 is a part projecting from the inner surface 1b of the first wall part 1. Furthermore, taking the inner surface 1b of the first wall part 1 as a reference surface, the height of the projecting part 13 from the reference surface ranges from 0.2 mm to 5 mm, for example, and the width of the projecting part 13 may be greater than the height of the projecting part 13. As illustrated in FIG. 5, the cross-sectional shape of the projecting part 13 may be rectangular. Additionally, the top surface of the projecting part 13 is a surface that includes the highest point of the projecting part 13, and is a surface parallel to the outer surface 1a of the first wall part 1.

With this configuration satisfied, compared with a configuration with no projecting part 13, the surface area is increased by an amount equal to the surface area of the projecting part 13, and the cooling efficiency of the heat dissipation member 10 of the present disclosure can be improved.

Here, the projecting part 13 may be made of the same material as the first wall part 1. However, in a case where the projecting part 13 is made of aluminum or copper, the heat transfer property of the projecting part 13 itself is improved, and the cooling efficiency of the heat dissipation member 10 of the present disclosure can be improved.

Additionally, as illustrated in FIG. 5, the first metal layer 6 of the heat dissipation member 10 of the present disclosure may cover all of the projecting part 13. Here, "cover all of the projecting part 13" refers to the surface of the projecting part 13 being completely covered by the first metal layer 6 so that none of the projecting part 13 is exposed to the outside.

With this configuration satisfied, heat transferred to the projecting part 13 can be efficiently transmitted to the first metal layer 6 via the conductive layer 5 and the first wall part 1, and the cooling efficiency of the heat dissipation members 10 of the present disclosure can be improved.

Next, an example of a manufacturing method for a heat dissipation member and an electronic device provided with the same according to the present disclosure will be described. In the example described here, the first wall part is a ceramic.

First, a sintering aid, a binder, a solvent, or the like is added to a powder of the raw material corresponding to the main component (aluminum oxide, silicon nitride, or the like) and mixed accordingly to produce a slurry. Next, this slurry is used to form a green sheet with a desired shape by using the doctor blade method to form a sheet which is then punched out using a die or machined with a laser. Alternatively, the slurry is spray-dried to obtain granulated granules. Then, the granules are rolled out to form a green sheet with a desired shape and punched out using a die or machined with a laser. Then, the green sheet can be fired to obtain the first wall part. Note that in a case where the projecting part is formed of the same material as the first wall part, the part corresponding to the projecting part may be formed by layering the green sheet, after which firing takes place.

Next, a conductive layer is formed on the surface of the first wall part. Examples of the method for forming the conductive layer include a diffusion bonding method of promoting diffusion of atoms between bonding materials by pressing and heating; a direct bonding method of directly adhering a metal sheet, such as a copper sheet or an aluminum sheet; an active metal bonding (AMB) method of bonding a metal sheet via a brazing material, such as silver or copper to which an active metal, such as titanium, zirconium, hafnium, or niobium is added; a printing method of forming the conductive layer using a paste with a metal component as a main component; a sputtering method of forming the conductive layer via sputtering using titanium or chromium as a base layer; a plating method of forming the conductive layer after forming a base layer of titanium or chromium or forming fine recesses and protrusions; and the like. Note that, in a case where the projecting part is made of copper or aluminum, the projecting part may be formed by the same forming method as the conductive layer described above.

Next, a first metal layer is formed on the opposite surface of the first wall part to where the conductive layer is formed. First, a mask of a desired shape made of a resin is formed on the surface of the first wall part. Next, a liquid mixture in which a plurality of metal particles made of stainless steel, aluminum, or copper is mixed into a liquid such as water is prepared, and the mixture is poured into the space formed by the mask. This is then dried to evaporate the liquid. Thereafter, the mask is removed by burning or using a solvent, pressed at a predetermined pressure, and then the base is heated or ultrasonically vibrated. In this manner, the metal particles can be bonded together, and the first metal particles and the second metal particles can be welded together. Accordingly, a first metal layer with gaps can be obtained. Additionally, a welded part can be formed between the first metal particles and the third metal particles.

Note that instead of directly forming the first metal layer on the surface of the first wall part, first, a bonding layer may be formed on the surface of the first wall part, and then the first metal layer may be formed on the bonding layer. Here, the bonding layer is a metal, glass, or porous ceramic. In a case where the bonding layer is a metal, the bonding layer may be formed using a sputtering method after the mask is formed, or may be formed using an electroless plating method or a metallizing method. On the other hand, when the bonding layer is a glass or porous ceramic, the bonding layer may be formed before the mask is formed. In this case, the glass and the porous ceramic may be formed by applying a paste having each of the aforementioned as a main component to the inner surface of the first wall part and performing heat treatment. Additionally, because the glass and the porous ceramic have insulating properties, they may be formed so as to cover all of the surface of the first wall part. Note that the porous ceramic is easily bonded to the base as long as it is made of the same components as the ceramic constituting the first wall part.

Then, after forming the first metal layer on the bonding layer, in the case where the bonding layer is a metal or glass, the base is heated to bond the bonding layer to the first metal layer by wetting. In addition, in a case where the bonding layer is a porous ceramic, the first metal particles, the second metal particles, and the third metal particles constituting the first metal layer are bonded to the bonding layer by penetrating into the porous ceramic. Note that in a case where the bonding layer is a metal, the metal of the bonding layer and the first metal particles, the second metal particles, and/or the third metal particles constituting the first metal layer can be bonded by running electricity through the bonding layer and the first metal layer to bond together the bonding layer and the first metal layer.

Note that a base including the first metal layer may be obtained by preparing a first metal layer separately, placing the first metal layer on a bonding layer formed in advance on the surface or applying a paste corresponding to the bonding layer on the first metal layer and then placing the first metal layer on the surface, and then heating the base. In this case, the first metal layer is made in advance by the following method. First, a liquid mixture in which a plurality of metal particles made of stainless steel, aluminum, or copper are mixed into a liquid such as water is prepared, and the mixture is poured into a mold with the shape of the first metal layer. This is then dried to evaporate the liquid. Next, the first metal particles and the second metal particles are welded together by applying a predetermined amount of pressure, heating, or ultrasonic vibration. Additionally, a welded part can be formed between the first metal particles and the third metal particles. Then, when extracted from the mold, a first metal layer including gaps is obtained.

Note that the first metal layer may be made by the following method. First, after the first metal particles, the second metal particles, and/or the third metal particles and the binder are mixed together, a molded article is produced by a mechanical pressing method. The compact is then dried to evaporate the binder. Then, it is heated or ultrasonically vibrated. In this manner, the first metal particles and the second metal particles can be welded together. Additionally, a welded part can be formed between the first metal particles and the third metal particles. Accordingly, a first metal layer with gaps is obtained.

Note that in order to cover the metal particles with an oxide film, an oxide film such as a passive film may be formed on the surface of the metal particles by performing an oxidation treatment using a strong oxidant, heating in an oxygen atmosphere, an anodizing treatment, or the like on the first metal particles, the second metal particles, and/or the third metal particles.

Note that in a case where the first wall part includes a projecting part, the first metal layer may be formed on the projecting part via the method described above.

Then, the heat dissipation member of the present disclosure is obtained by placing an adhesive between the first wall part where the conductive layer and the first metal layer are formed and the second wall part and the third wall part, and performing heat treatment. Here, for example, a silicon-based brazing material or a polyimide-based adhesive may be used as the adhesive.

Furthermore, the electronic device of the present disclosure can be obtained by placing a silver-based brazing material, tin-based solder, gold-, silver-, copper-, or nickel-based nanopaste, or the like on the conductive layer of the heat dissipation member, then placing the electronic component on this, and performing heat treatment.

### Reference Signs List

1: First wall part
2: Second wall part
3: Third wall part
4: Flow path
5: Conductive layer
6: First metal layer
7: Electronic component
8: Inflow opening
9: Outflow opening
10a, 10b, 10 Heat dissipation member
11a: First metal particle
11b: Second metal particle
11c: Third metal particle
12: Bonding layer
13: Projecting part
14: Welded part
15: Oxide film
16: Gap
20a, 20b, 20: Electronic device

## Claims

1. A heat dissipation member (10), comprising:
a first wall part (1) with insulating properties;
a second wall part (2) located opposite the first wall part (1);
a third wall part (3) located between the first wall part (1) and the second wall part (2);
a flow path (4) surrounded by the first wall part (1), the second wall part (2), and the third wall part (3);
a conductive layer (5) located on an outer surface (1a) of the first wall part (1); and
a first metal layer (6) located on an inner surface (1b) of the first wall part (1), the first metal layer (6) comprising gaps (16), wherein
the first metal layer (6) comprises first metal particles (11a) and second metal particles (11b); and
the gaps (16) are located between the first metal particles (11a) and the second metal particles (11b), **characterised in that**
the first metal particles (11a) and the second metal particles (11b) are covered with an oxide film (15).

2. The heat dissipation member (10) according to claim 1, further comprising:
a bonding layer (12) located between the first metal layer (6) and the inner surface (1b) of the first wall part (1) .

3. The heat dissipation member (10) according to claim 2, wherein
the bonding layer (12) is made of a porous ceramic.

4. A heat dissipation member (10), comprising:
a first wall part (1) with insulating properties;
a second wall part (2) located opposite the first wall part (1);
a third wall part (3) located between the first wall part (1) and the second wall part (2);
a flow path (4) surrounded by the first wall part (1), the second wall part (2), and the third wall part (3);
a conductive layer (5) located on an outer surface (1a) of the first wall part (1); and
a first metal layer (6) located on an inner surface (1b) of the first wall part (1), the first metal layer (6) comprising gaps (16);
the heat dissipation member (10) further comprising:
a bonding layer (12) located between the first metal layer (6) and the inner surface (1b) of the first wall part (1), **characterised in that**
the bonding layer (12) is made of a porous ceramic.

5. The heat dissipation member (10) according to claim 4, wherein
the first metal layer (6) comprises first metal particles (11a) and second metal particles (11b); and
the gaps (16) are located between the first metal particles (11a) and the second metal particles (11b).

6. The heat dissipation member (10) according to anyone of claims 1 to 3 and 5, wherein
the first metal layer (6) further comprises third metal particles (11c); and
the first metal layer (6) comprises a welded part (14) between the first metal particles (11a) and the third metal particles (11c).

7. The heat dissipation member (10) according to any one of claims 1 to 6, wherein
the first wall part (1) is made of a ceramic.

8. The heat dissipation member (10) according to anyone of claims 2 to 5, claim 6 when referring back directly or indirectly to claim 2 and claim 7 when referring back directly or indirectly to claim 2, wherein
the bonding layer (12) is made of a metal or glass.

9. The heat dissipation member (10) according to any one of claims 1 to 8, wherein
the first metal layer (6) is located directly below the conductive layer (5).

10. The heat dissipation member (10) according to any one of claims 1 to 9, wherein
the first wall part (1) comprises a projecting part (13) projecting toward the flow path (4); and
the first metal layer (6) is located on a top surface of the projecting part (13).

11. The heat dissipation member (10) according to claim 10, wherein
the first metal layer (6) completely covers the projecting part (13).

12. An electronic device (20), comprising:
the heat dissipation member (10) according to any one of claims 1 to 11; and
an electronic component (7) located on the conductive layer (5) of the heat dissipation member (10).

## Patentansprüche

1. Wärmeabfuhrelement (10), aufweisend:
einen ersten Wandteil (1) mit isolierenden Eigenschaften,
einen zweiten Wandteil (2), der dem ersten Wandteil (1) gegenüber angeordnet ist,
einen dritten Wandteil (3), der zwischen dem ersten Wandteil (1) und dem zweiten Wandteil (2) angeordnet ist,
einen Strömungspfad (4), der von dem ersten Wandteil (1), dem zweiten Wandteil (2) und dem dritten Wandteil (3) umgeben ist,
eine leitfähige Schicht (5), die auf einer Außenfläche (1a) des ersten Wandteils (1) angeordnet ist, und
eine erste Metallschicht (6), die auf einer Innenfläche (1b) des ersten Wandteils (1) angeordnet ist, wobei die erste Metallschicht (6) Lücken (16) aufweist, wobei
die erste Metallschicht (6) erste Metallpartikel (11a) und zweite Metallpartikel (11b) aufweist und
die Lücken (16) zwischen den ersten Metallpartikeln (11a) und den zweiten Metallpartikeln (11b) angeordnet sind,
**dadurch gekennzeichnet, dass**
die ersten Metallpartikel (11a) und die zweiten Metallpartikel (11b) mit einem Oxidfilm (15) bedeckt sind.

2. Wärmeabfuhrelement (10) gemäß Anspruch 1, ferner aufweisend:
eine Verbindungsschicht (12), die zwischen der ersten Metallschicht (6) und der Innenfläche (1b) des ersten Wandteils (1) angeordnet ist.

3. Wärmeabfuhrelement (10) gemäß Anspruch 2, wobei
die Verbindungsschicht (12) aus einer porösen Keramik hergestellt ist.

4. Wärmeabfuhrelement (10), aufweisend:
einen ersten Wandteil (1) mit isolierenden Eigenschaften,
einen zweiten Wandteil (2), der dem ersten Wandteil (1) gegenüber angeordnet ist,
einen dritten Wandteil (3), der zwischen dem ersten Wandteil (1) und dem zweiten Wandteil (2) angeordnet ist,
einen Strömungspfad (4), der von dem ersten Wandteil (1), dem zweiten Wandteil (2) und dem dritten Wandteil (3) umgeben ist,
eine leitfähige Schicht (5), die auf einer Außenfläche (1a) des ersten Wandteils (1) angeordnet ist, und
eine erste Metallschicht (6), die auf einer Innenfläche (1b) des ersten Wandteils (1) angeordnet ist, wobei die erste Metallschicht (6) Lücken (16) aufweist,
wobei das Wärmeabfuhrelement (10) ferner aufweist:
eine Verbindungsschicht (12), die zwischen der ersten Metallschicht (6) und der Innenfläche (1b) des ersten Wandteils angeordnet ist, **dadurch gekennzeichnet, dass**
die Verbindungsschicht (12) aus einer porösen Keramik hergestellt ist.

5. Wärmeabfuhrelement (10) gemäß Anspruch 4, wobei
die erste Metallschicht (6) erste Metallpartikel (11a) und zweite Metallpartikel (11b) aufweist, und
die Lücken (16) zwischen den ersten Metallpartikeln (11a) und den zweiten Metallpartikeln (11b) angeordnet sind.

6. Wärmeabfuhrelement (10) gemäß irgendeinem der Ansprüche 1 bis 3 und 5, wobei
die erste Metallschicht (6) ferner dritte Metallpartikel (11c) aufweist, und
die erste Metallschicht (6) einen geschweißten Teil (14) zwischen den ersten Metallpartikeln (11a) und den dritten Metallpartikeln (11c) aufweist.

7. Wärmeabfuhrelement (10) gemäß irgendeinem der Ansprüche 1 bis 6, wobei
der erste Wandteil (1) aus einer Keramik hergestellt ist.

8. Wärmeabfuhrelement (10) gemäß irgendeinem der Ansprüche 2 bis 5, Anspruch 6 bei direktem oder indirektem Rückbezug auf Anspruch 2, und Anspruch 7 bei direktem oder indirektem Rückbezug auf Anspruch 2, wobei
die Verbindungsschicht (12) aus einem Metall oder Glas hergestellt ist.

9. Wärmeabfuhrelement (10) gemäß irgendeinem der Ansprüche 1 bis 8, wobei
die erste Metallschicht (6) direkt unter der leitfähigen Schicht (5) angeordnet ist.

10. Wärmeabfuhrelement (10) gemäß irgendeinem der Ansprüche 1 bis 9, wobei
der erste Wandteil (1) einen in Richtung zu dem Strömungspfad (4) hervorstehenden Vorsprungsteil (13) aufweist, und
die erste Metallschicht (6) auf einer oberen Fläche des hervorstehenden Teils (13) angeordnet ist.

11. Wärmeabfuhrelement (10) gemäß Anspruch 10, wobei
die erste Metallschicht (6) den Vorsprungsteil (13) vollständig bedeckt.

12. Elektronische Vorrichtung (20), aufweisend:
das Wärmeabfuhrelement (10) gemäß irgendeinem der Ansprüche 1 bis 11 und
eine elektronische Komponente (7), die auf der leitfähigen Schicht (5) des Wärmeabfuhrelements (10) angeordnet ist.

## Revendications

1. Élément de dissipation thermique (10), comprenant :
une première partie de paroi (1) ayant des propriétés isolantes ;
une deuxième partie de paroi (2) située à l'opposé de la première partie de paroi (1) ;
une troisième partie de paroi (3) située entre la première partie de paroi (1) et la deuxième partie de paroi (2) ;
une voie d'écoulement (4) entourée par la première partie de paroi (1), la deuxième partie de paroi (2) et la troisième partie de paroi (3) ;
une couche conductrice (5) située sur une surface extérieure (1a) de la première partie de paroi (1) ; et
une première couche métallique (6) située sur une surface intérieure (1b) de la première partie de paroi (1), la première couche métallique (6) comprenant des espaces (16), où
la première couche métallique (6) comprend des premières particules métalliques (11a) et des deuxièmes particules métalliques (11b) ; et
les espaces (16) sont situés entre les premières particules métalliques (11a) et les deuxièmes particules métalliques (11b),
**caractérisé en ce que**
les premières particules métalliques (11a) et les deuxièmes particules métalliques (11b) sont recouvertes d'un film d'oxyde (15).

2. Élément de dissipation thermique (10) selon la revendication 1, comprenant en outre :
une couche de liaison (12) située entre la première couche métallique (6) et la surface intérieure (1b) de la première partie de paroi (1).

3. Élément de dissipation thermique (10) selon la revendication 2, dans lequel
la couche de liaison (12) est constituée d'une céramique poreuse.

4. Élément de dissipation thermique (10), comprenant :
une première partie de paroi (1) ayant des propriétés isolantes ;
une deuxième partie de paroi (2) située à l'opposé de la première partie de paroi (1) ;
une troisième partie de paroi (3) située entre la première partie de paroi (1) et la deuxième partie de paroi (2) ;
une voie d'écoulement (4) entourée par la première partie de paroi (1), la deuxième partie de paroi (2) et la troisième partie de paroi (3) ;
une couche conductrice (5) située sur une surface extérieure (1a) de la première partie de paroi (1) ; et
une première couche métallique (6) située sur une surface intérieure (1b) de la première partie de paroi (1), la première couche métallique (6) comprenant des espaces (16) ;
l'élément de dissipation thermique (10) comprenant en outre :
une couche de liaison (12) située entre la première couche métallique (6) et la surface intérieure (1b) de la première partie de paroi, **caractérisé en ce que**
la couche de liaison (12) est constituée d'une céramique poreuse.

5. Élément de dissipation thermique (10) selon la revendication 4, dans lequel
la première couche métallique (6) comprend des premières particules métalliques (11a) et des deuxièmes particules métalliques (11b) ; et
les espaces (16) sont situés entre les premières particules métalliques (11a) et les deuxièmes particules métalliques (11b).

6. Élément de dissipation thermique (10) selon l'une quelconque des revendications 1 à 3 et 5, dans lequel
la première couche métallique (6) comprend en outre des troisièmes particules métalliques (11c) ; et
la première couche métallique (6) comprend une partie soudée (14) entre les premières particules métalliques (11a) et les troisièmes particules métalliques (11c).

7. Élément de dissipation thermique (10) selon l'une quelconque des revendications 1 à 6, dans lequel
la première partie de paroi (1) est constituée d'une céramique.

8. Élément de dissipation thermique (10) selon l'une quelconque des revendications 2 à 5, la revendication 6 lorsqu'elle se réfère directement ou indirectement à la revendication 2, et la revendication 7 lorsqu'elle se réfère directement ou indirectement à la revendication 2, dans lequel
la couche de liaison (12) est constituée de métal ou de verre.

9. Élément de dissipation thermique (10) selon l'une quelconque des revendications 1 à 8, dans lequel
la première couche métallique (6) est située directement sous la couche conductrice (5).

10. Élément de dissipation thermique (10) selon l'une quelconque des revendications 1 à 9, dans lequel
la première partie de paroi (1) comprend une partie saillante (13) faisant saillie vers la voie d'écoulement (4) ; et
la première couche métallique (6) est située sur une surface supérieure de la partie saillante (13).

11. Élément de dissipation thermique (10) selon la revendication 10, dans lequel
la première couche métallique (6) recouvre entièrement la partie saillante (13).

12. Dispositif électronique (20), comprenant :
l'élément de dissipation thermique (10) selon l'une quelconque des revendications 1 à 11 ; et
un composant électronique (7) situé sur la couche conductrice (5) de l'élément de dissipation thermique (10).
